# EUROPEAN PATENT APPLICATION

(11) **EP 4 571 811 A2**
(43) Date of publication of application: **18.06.2025**
(21) Application number: 25173773.0
(22) Date of filing: 30.04.2025
(51) Int. Cl.: H01J 37/244, H01J 37/28

(54) **CROSS TALK REDUCTION**

(71) Applicant: ASML Netherlands B.V., 5500 AH Veldhoven (NL)
(72) Inventor: REN, Yan, 5500 AH Veldhoven (NL); HUANG, Zhuangxiong, 5500 AH Veldhoven (NL)
(74) Representative: ASML Netherlands B.V.

(57) **Abstract**

A charged particle-optical apparatus is configured to direct charged particles toward a sample. A charged particle-optical device is configured to direct a plurality of beams of charged particles along respective beam paths toward a sample. A detector array of detector elements is configured to detect signal charged particles emitted from respective areas of a surface of the sample so as to generate respective detection signals. A controller is configured to determine cross talk values indicative of proportions of each detection signal resulting from the detector element detecting signal charged particles emitted from areas other than its respective area. The controller is configured to reduce cross talk by operating on the detection signals using the determined cross talk values based on signals resulting from subsets of the primary beams on the sample.

## Description

### FIELD

The present invention relates to a charged particle-optical apparatus, a method for reducing cross talk of detection signals, a method for assessing a sample, a computer readable medium, a scanning electron microscope (SEM), a method of operating a SEM and a non-transitory computer readable medium.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a SEM). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

Multiple probe beams may be used at the same time so as to speed up assessment of a sample. Data representing the probed parts of the substrates may be collected by separate detectors, thereby enabling parallel data acquisition across many points of interest on the substrate. Interaction products originating from a particular probe beam can be partially detected by the detectors of neighboring probe beams. This is known as cross talk. Cross talk can be reduced by narrowing the apertures through which the probe beams are directed towards the substrate. However, this reduces the amount of collected electrons, thereby reducing the overall data collected.

### SUMMARY

It is desirable to reduce cross talk, without unduly reducing the overall signal.

An embodiment of the present disclosure provides a charged particle-optical apparatus configured to direct charged particles toward a sample, the charged particle-optical apparatus comprising:
a charged particle-optical device configured to direct a plurality of beams of charged particles along respective beam paths toward a sample;
a detector array of detector elements configured to detect signal charged particles emitted from respective areas of a surface of the sample so as to generate respective detection signals; and
a controller configured to:
   determine cross talk values indicative of proportions of each detection signal resulting from the detector element detecting signal charged particles emitted from areas other than its respective area; and
   reduce cross talk by operating on the detection signals using the determined cross talk values based on signals resulting from subsets of the primary beams on the sample.

An embodiment of the present disclosure provides a method for reducing cross talk of detection signals, of signal charged particles emitted from respective areas of a surface of a sample resulting from primary beams of charged particles on the sample, detected by detector elements, the method comprising:
determining cross talk values indicative of proportions of each detection signal resulting from the detector element detecting signal charged particles emitted from areas other than its respective area; and
reducing cross talk by operating on the detection signals using the determined cross talk values based on signals resulting from subsets of the primary beams on the sample.

An embodiment of the present disclosure provides a method for assessing a sample with primary beams of charged particles,, the method comprising:
directing a plurality of primary beams of charged particles toward a sample;
detecting with detector elements signal charged particles emitted from respective areas of a surface of the sample so as to generate detection signals.
determining cross talk values indicative of proportions of each detection signal resulting from the detector element detecting signal charged particles emitted from areas other than its respective area; and
reducing cross talk of the detection signals by operating on the detection signals using the determined cross talk values based on signals resulting from subsets of the primary beams on the sample.

An embodiment of the present disclosure provides a computer readable medium storing instructions that, when executed by at least one processor, cause a computing device to perform a method for reducing cross talk of detection signals, detected by detector elements, of signal charged particles emitted from respective areas of a surface of a sample resulting from primary beams of charged particles on the sample, the method comprising:
determining cross talk values indicative of proportions of each detection signal resulting from the detector element detecting signal charged particles emitted from areas other than its respective area; and
reducing cross talk by operating on the detection signals using the determined cross talk values based on signals resulting from subsets of the primary beams on the sample.

An embodiment of the present disclosure provides a SEM for scanning a sample with electrons and detecting signal electrons emitted from the sample, the SEM comprising:
an electron-optical device configured to direct a plurality of electron beams onto a field of view of the sample;
a detector comprising a plurality of detector elements configured to detect signal electrons emitted from respective locations within the field of view, so as to generate SEM scan data; and
a controller configured to:
   determine cross talk values indicative of proportions of each SEM scan datum resulting from the detector element detecting signal electrons emitted from locations other than its respective location; and
   reduce cross talk by operating on the SEM scan data using the determined cross talk values based on signals resulting from subsets of the primary beams on the sample.

An embodiment of the present disclosure provides a method of operating a SEM for scanning a sample with electrons and detecting signal electrons emitted from the sample, the method comprising:
an electron-optical device of the SEM directing a plurality of electron beams onto a field of view of the sample;
a plurality of detector elements of a detector of the SEM detecting signal electrons emitted from respective locations within the field of view, so as to generate SEM scan data; and
a controller of the SEM determining cross talk values indicative of proportions of each SEM scan datum resulting from the detector element detecting signal electrons emitted from locations other than its respective location; and
the controller reducing cross talk by operating on the SEM scan data using the determined cross talk values based on signals resulting from subsets of the primary beams on the sample.

An embodiment of the present disclosure provides a non-transitory computer readable medium that stores instructions for a processor of a controller to carry out a method of operating a scanning electron microscope, SEM, the method comprising:
controlling an electron-optical device of the SEM to direct an electron beam onto a field of view of a sample;
controlling a plurality of detector elements of a detector of the SEM to detect signal electrons emitted from respective locations within the field of view, so as to generate SEM scan data;
determining cross talk values indicative of proportions of each SEM scan datum resulting from the detector element detecting signal electrons emitted from locations other than its respective location; and
reducing cross talk by operating on the SEM scan data using the determined cross talk values based on signals resulting from subsets of the primary beams on the sample.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts an alternative multi-beam charged particle-optical device, for example of the assessment apparatus of Figure 1;
- Figure 4 schematically depicts a multi-beam charged particle-optical device, for example of the assessment apparatus of Figure 1;
- Figure 5 schematically depicts an alternative multi-beam charged particle-optical device, for example of the assessment apparatus of Figure 1;
- Figure 6 schematically depicts a charged particle-optical device array;
- Figure 7 schematically depicts a detector array in plan view;
- Figure 8 schematically depicts a detector element in cross-section;
- Figure 9 is a flow chart of a method for reducing cross talk of detection signals; and
- Figure 10 is a flow chart for determining cross talk values.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7.7%. It is desirable to determine defects quickly so as to maintain a high substrate throughput, defined as the number of substrates processed per hour.

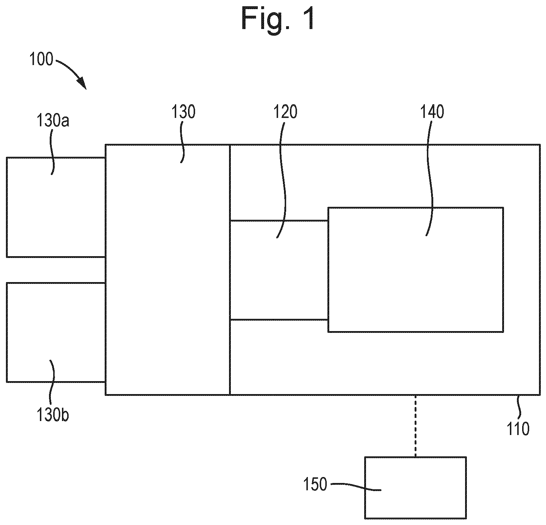

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

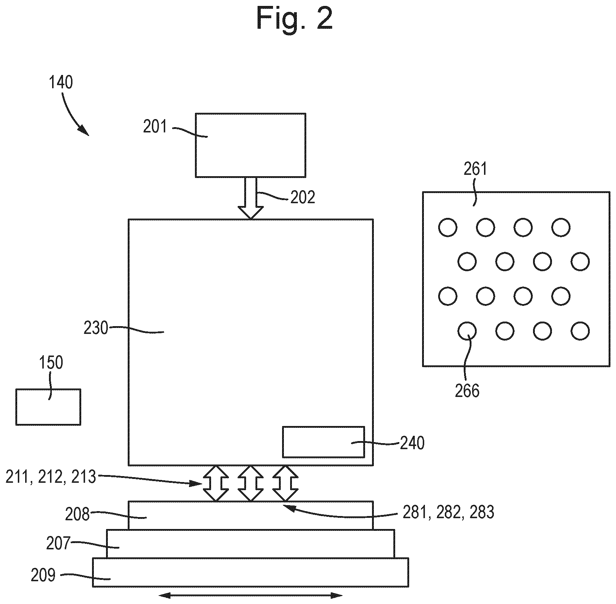

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to as an array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

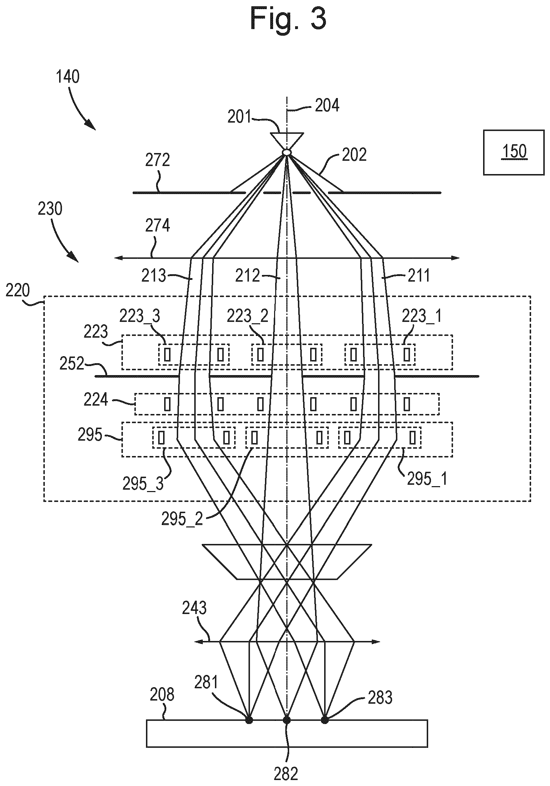

Figure 3 schematically depicts an electron-optical apparatus 140 of an assessment apparatus, e.g. the assessment apparatus 100 of Figure 1. The electron-optical apparatus 140 comprises an electron-optical device 230. The field of view of the electron-optical device 230 may be, for example, of the order of 100s of microns across the primary beams 211, 212, 213 at the sample 208. The electron-optical apparatus 140 of Figure 3 may be the electron-optical apparatus 140 of Figure 2 in which the electron-optical device 230 comprises a Coulomb aperture array 272, a macro condenser lens 274, a source converter (or micro-optical array) 220 and an objective lens 243. The electron-optical apparatus 140 defines an electron-optical axis 204. The Coulomb aperture array 272 may be referred to as a beam former array.

The source 201 generates a source beam 202. The Coulomb aperture array 272 defines a plurality of primary beams 211, 212, 213 from the source beam 202. The Coulomb aperture array 272, in operation, is configured to block off peripheral electrons to reduce electron-electron interactions (also referred to as Coulomb interactions) that may generate aberrations.

The macro condenser lens 274 is configured to at least partly collimate the primary beams 211, 212, 213. In an embodiment the macro condenser lens 274 is magnetic. The macro condenser lens 274 may be a non-rotational condenser lens. In an embodiment the macro condenser lens 274 is configured to operate on a plurality of, optionally all of, the primary beams 211, 212, 213.

The source converter 220 is configured to convert the primary beams 211, 212, 213 transmitted by the Coulomb aperture array 272 into the beams that are directed towards the sample 208. In an embodiment the source converter 220 is a module. Alternatively, the source converter 220 may comprise a plurality of separate electron-optical elements.

In an embodiment the source converter 220 comprises a pre-bending deflector array 223 with pre-bending deflectors 223_1, 223_2, 223_3 configured to deflect respective primary beams 211, 212, 213 toward a beam limiting aperture array 252.

In an embodiment the source converter 220 comprises a beam limiting aperture array 252 with an aperture pattern (i.e. apertures arranged in a formation) configured to define the outer dimensions of the primary beams 211, 212, 213 directed towards the sample 208. The beam limiting aperture array 252 may be a plate 261. In an embodiment, the beam limiting aperture array 252 defines a plurality of beams from each of the primary beams 211, 212, 213 directed to the beam limiting aperture array 252. In an alternative embodiment, the beam limiting aperture array 252 maintains the number of the primary beams 211, 212, 213 incident on the beam limiting aperture array 252.

The source converter 220 may comprise a corrector array such as an aberration reduction array 224 configured to reduce aberrations of the primary beams 211, 212, 213. In an embodiment the aberration reduction array 224 comprises a plurality of lenses configured to operate on respective primary beams 211, 212, 213. The aberration reduction array 224 may, for example, comprise a field curvature compensator array (not shown) comprising lenses. The aberration reduction array 224 may comprise an astigmatism compensator array (not shown) comprising stigmators. The stigmators may, for example, be controlled to operate on the primary beams 211, 212, 213 to reduce astigmatism aberrations.

The source converter 220 may comprise a deflector array 295 comprising deflectors 295_1, 295_2, 295_3 for the beam paths of respective primary beams 211, 212, 213. The deflectors 295_1, 295_2, 295_3 are configured to deflect the beam paths of the primary beams 211, 212, 213 towards the front focal plane of the objective lens 243 to ensure that the individual primary beams 211, 212, 213 will impinge on the sample 208 substantially perpendicular.

In an embodiment the objective lens 243 is magnetic. In an embodiment the objective lens 243 is a macroscopic lens configured to manipulate a plurality of, optionally all of, the primary beams 211, 212, 213 simultaneously. The objective lens 243 focuses the primary beams 211, 212, 213 onto the surface of the sample 208. The primary beams 211, 212, 213 form respective probe spots 281, 282, 283 on the surface of the sample 208. The deflectors 295_1, 295_2, 295_3 of the deflector array 295 deflect the individual primary beams 211, 212, 213 to the front focal plane of the objective lens to ensure that the individual primary beams 211, 212, 213, in use, impinge on the substrate 208 substantially perpendicular. In an embodiment the objective lens 243 is a macroscopic lens containing both magnetic and electrostatic lenses. In such an embodiment the macroscopic electrostatic lenses manipulate the plurality of the primary beams 211, 212, 213 simultaneously. In a further embodiment, the objective lens 243 comprises one or more scan deflectors (electrostatic and/or magnetic) to scan the plurality of primary beams 211, 212, 213 over the substrate 208.

In an embodiment the electron-optical apparatus 140 comprises a secondary electron-optical device (not shown) comprising a detector array 240. In such an embodiment a beam separator typically is arranged to deflect the path of the signal electrons towards the secondary electron-optical device. The secondary electron-optical device subsequently directs the signal electrons towards the detector array 240 and focuses the signal electrons (e.g. secondary electrons) onto the detector array 240.

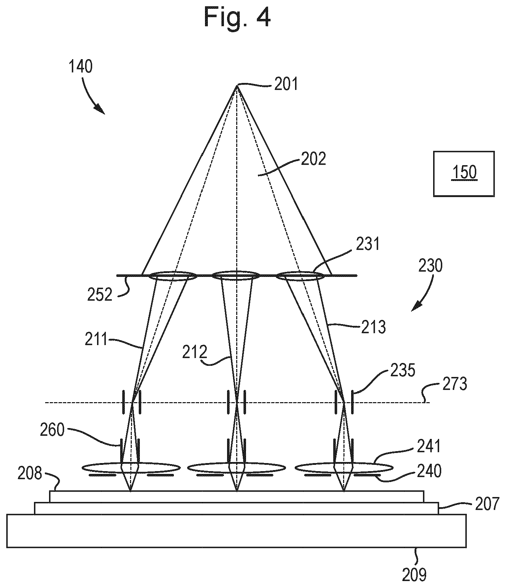

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 4, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

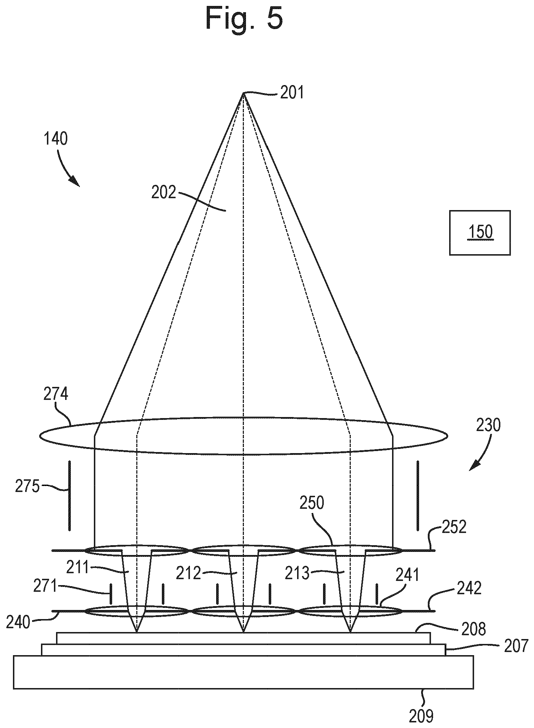

Figure 5 schematically depicts an electron-optical apparatus 140 of an assessment apparatus, e.g. the assessment apparatus 100 of Figure 1. The electron-optical apparatus 140 of Figure 5 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The **collimator** array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

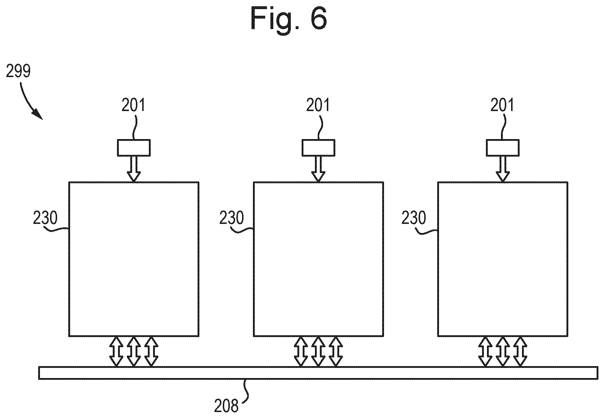

Figure 6 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

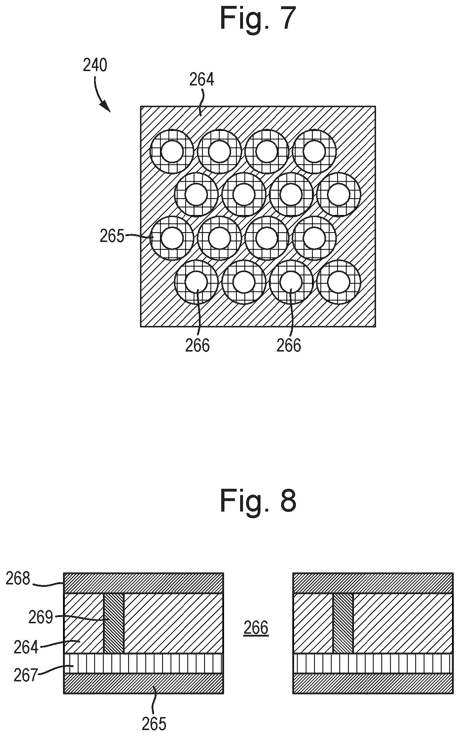

Figure 7 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 7, the beam apertures 266 are in a hexagonal close packed array. The beam apertures 266 can also be differently arranged, e.g. in a rectangular array.

Figure 8 depicts at a larger scale a part of the detector array 240 in cross section. The detector elements 265 form the bottom surface, i.e. the surface the closest to the sample 208, of the detector array 240. Between the detector elements 265 and the main body of the detector substrate 264 a logic layer 267 may be provided. At least part of the signal processing system, for example for amplification, may be incorporated into the logic layer 267.

A wiring layer 268 is provided on the backside of, or within, the detector substrate 264 and connected to the logic layer 267 by through-substrate vias 269. The number of through-substrate vias 269 need not be the same as the number of beam apertures 266. In particular if the electrode signals are digitized in the logic layer 267 only a small number of through-silicon vias may be required to provide a data bus. The wiring layer 268 may include control lines, data lines and power lines. It will be noted that in spite of the beam apertures 266 there is ample space for all necessary connections. The detector array 240 may be fabricated using CMOS technology, but may also be fabricated using bipolar or other manufacturing techniques. A printed circuit board and/or other semiconductor chips may be provided on the detector array 240.

In an embodiment, the controller 150 is configured to control the electron-optical device 230. The controller 150 may be configured to control potentials applied to electrodes of lenses of the electron-optical device 230.

In an embodiment the controller 150 is configured to control the actuatable stage 209 to move the sample 208 during inspection of the sample 208. The controller 150 may enable the actuatable stage 209 to move the sample 208 in a direction, for example continuously, such as at a constant speed, at least during sample inspection, which may be referred to as a type of scanning. The speed of the actuatable stage 209 may be referred to as the moving rate. The controller 150 may control movement of the actuatable stage 209 so as to change the speed of movement of the sample 208 relative to the beam paths dependent on one or more parameters. The controller 150 may control deflection of scan deflectors so that the beam paths move relative to the actuatable stage 209 and thus over the surface of the sample 208. The controller 150 may change a beam deflection of a scan deflector and thus the scanning of the primary beams 211, 212, 213 over the sample 208 dependent on one or more parameters. For example, the controller 150 may control a scan deflector and/or the speed of the actuatable stage 209 and/or the direction of movement of the actuatable stage 209 depending on characteristics of the assessment process. The disclosure in EP4086933 A1 of a combined stepping and scanning strategy of the stage and scanning deflectors is hereby incorporated by reference. The moving rate may at different times comprise a stepping frequency and/or a stage scanning rate.

As described above, the electron-optical apparatus 100 is configured to direct electrons towards a sample 208. The electron-optical apparatus140 comprises an electron-optical device 230. The electron-optical device 230 is configured to direct a plurality of primary beams 211, 212, 213 of electrons along respective beam paths towards the sample 208. The electron-optical apparatus 140 comprises a detector array 240 of detector elements 265. The detector array 240 of detector elements 265 is configured to detect signal electrons emitted from respective areas of a surface of the sample 208 so as to generate respective detection signals.

The detector elements 265 of the detector array 240 are configured to detect signal electrons emitted from respective portions of a surface of the sample 208 due to the interaction of the electrons of the primary beams with the sample 208. The detector elements 265 of are configured to generate detection signals for the respective portions of the surface of the sample 208. The detection signals are based on the detected signal electrons. For example, a detection signal may be indicative of a number of signal electrons detected by a corresponding detector element 265.

Each of the portions of the surface of the sample 208 may be associated with a respective primary beam 211, 212, 213. A primary beam may be directed by the electron-optical device 230 onto a portion of the surface of the sample. Interaction between the primary beam and the sample 208 results in signal electrons being emitted from the portion. The signal electrons are intended to be detected by the associated detector element 265 that corresponds to that potion and to that primary beam. However, some of these signal electrons generated from the interaction of a particular primary beam may be detected by detector elements 265 rather than the associated detector element 265. Or, said differently, primary beams surrounding a particular primary beam in the electron-optical device 230 may generate signal electrons which may end up at the detector element associated with the particular primary beam and as such distort the main image data captured by the associated detector element 265. This may be referred to as cross talk.

The detection signals comprise a proportion resulting from the detector element 265 detecting signal electrons emitted from the portion (or beam area) of the sample assigned to the detector elements. Such a portion may be a portion of the sample surface being scanned by the primary beam corresponding to the detector element 265. Every primary beam of the beam grid may be assigned such a portion. A proportion of the detection signal detected by a particular detection element 265 may result from detection of signal electrons emitted from a portion of the sample associated with a different primary beam of the beam grid and the primary beam associated with the particular detection element 265. This may be referred to as a cross talk proportion. Cross talk values are indicative of proportions of each detection signal resulting from the detector element 265 detecting signal electrons emitted from portions other than its respective portion. Cross talk values may be assigned for a plurality of the primary beams other than the primary beam corresponding to that detector element 265. In general, the cross talk values are expected to get smaller primary beams further from the primary beam associated with that detector element 265.

In an embodiment the controller 150 is configured to determine cross talk values. The cross talk values are indicative of proportions of each detection signal resulting from the detector element 265 detecting signal electrons emitted from areas other than its respective area. In an embodiment the controller 150 is configured to reduce cross talk by operating on the detection signals using the determined cross talk values based on signals resulting from subsets of the primary beams 211, 212, 213 on the sample 208. An embodiment of the invention is expected to reduce cross talk in the detection signals.

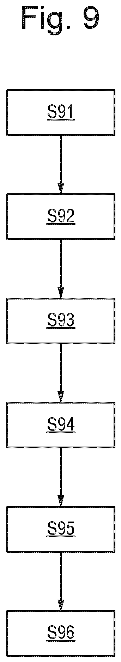

Figure 9 is a flow chart of a method for reducing cross talk in the detection signals. The method may be performed by the controller 150.

As shown in Figure 9, in an embodiment the method comprises a step S91 of controlling the electron-optical apparatus 140 to scan the sample 208. The scan comprises directing a plurality of primary beams 211, 212, 213 towards the sample 208.

As shown in Figure 9, in an embodiment the method comprises the step S92 of acquiring raw detector signals. The detector array 240 detects the signal electrons so as to generate respective detection signals. In an embodiment the scan comprises a scanning movement of the sample 208 relative to the electron-optical device 230. In an alternative embodiment, the relative positions between the electron-optical device 230 and the sample 208 are maintained during the scan of the sample 208.

It is not essential for the method to comprise detection of signals. For example, the detection signals may have previously been collected from a previous scan. The controller 150 may be configured to process the results of such a previous scan.

The raw detector signals are the detection signals generated by the detector array 240. In an embodiment the detector array 240 is configured to generate the detection signals from N channels. The number of channels N may correspond to the number of detector elements 265 and/or the number of primary beams 211, 212, 213 directed towards the sample 208. It is expected that there is some cross talk in the detection signals acquired by the detector array 240.

The acquired detection signals may be written and/or stored as a vector. For example, it is possible to define an N-element measured signal vector corresponding to the outputs of the N detector channels (i.e. the detector elements 265).

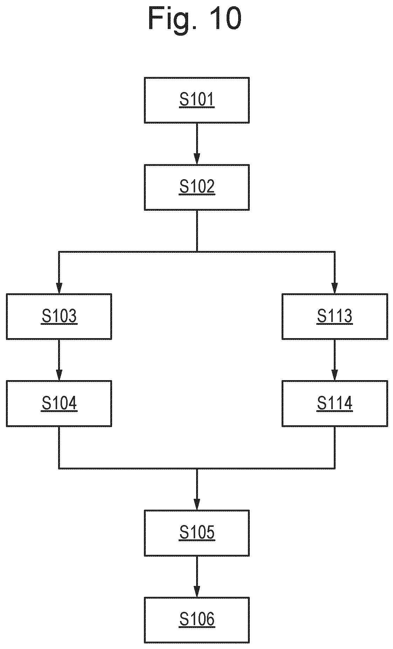

As shown in Figure 9, in an embodiment the method comprises the step S93 of providing or obtaining the cross talk values. In an embodiment the cross talk values are retrieved, for example obtained from a stored memory. In an alternative embodiment, the cross talk values are determined, for example calculated, as described in more detail with reference to Figure 10.

The cross talk values may be written and/or stored as a matrix. For example, a transfer matrix M comprises the cross talk values for the detector elements 265 of the detector array 240. The elements of the transfer matrix M describe how electrons generated by one of the particular primary beams appear in each particular detector channel (corresponding to the detector element 265). The transfer matrix **M** represents the effect of cross talk on the true (but unknown) electron contributions from the N primary beams 211, 212, 213. This relationship can be expressed as **Y** = **MX,** where **X** represents the true electron contributions in vector form and **Y** represents the measured electron contributions in vector form.

As shown in Figure 9, in an embodiment, the method comprises the step S94 of reducing cross talk by operating on the detection signals using the cross talk values . The cross talk values have been previously determined based on signals resulting from subsets of the primary beams on the sample.

For example, as mentioned above the cross talk values may form a transfer matrix **M.** In an embodiment the controller 150 is configured to reduce the cross talk by operation on the detection signals by operating on a pseudoinverse of the transfer matrix. In an alternative embodiment, the controller 150 is configured to reduce the cross talk by operating on the detection signals by an inverse of the transfer matrix. For example, when the transfer matrix **M** is invertible, then the inverse of the transfer matrix may be used. For example, the decoupled signals (i.e. the true electron contributions) can be computed as **X=M⁺Y** where **M⁺** represents the pseudoinverse (or inverse) **of M.**

In an embodiment the pseudoinverse of the transfer matrix **M** is the Moore-Penrose pseudoinverse of the transfer matrix **M.**

An embodiment of the invention is expected to reduce cross talk through a computational approach. In an embodiment the computational approach is based on a transfer matrix **M.** An embodiment of the invention is expected to reduce cross talk, without unduly reducing the signal strength. The signal intensity may be substantially maintained, while reducing the cross talk. An embodiment of the invention is expected to reduce cross talk, without unduly lowering the signal to noise ration.

By providing a higher to noise ratio for the given level of cross talk reduction, shorter integration times may be sufficient. By shortening the integration times, the throughput may be increased. An embodiment of the inventions is expected to increase throughput of assessment of samples 208.

An embodiment of the invention is expected to reduce cross talk, without requiring substantial redesign or repositioning of hardware components of the electron-optical apparatus 140. An embodiment of the invention is expected to reduce the cost of maintaining the electron-optical apparatus 140. An embodiment of the invention is expected to reduce the amount of time for which the electron-optical apparatus 140 cannot be used, for example because of redesign of maintenance.

As shown in Figure 9, in an embodiment the method comprises the step S95 of outputting the detection signals that have had the cross talk reduced. For example, the corrected per-beam signals may be output by the controller 150. In an embodiment the signals output by the controller 150 have reduced cross talk compared to the raw detector signals. In an embodiment the controller 150 is configured to output and/or store the corrected per-beam signals as a vector.

As shown in Figure 9, in an embodiment the method comprises the step S96. The step S96 may comprise ending the method. Alternatively, the step S96 may comprise next steps, for example image analysis.

In an embodiment the corrected detection signals may subsequently be processed/rendered. For example, the corrected detection signals may be processed to generate an image representation of part of the sample 208. In an embodiment the controller 150 is configured to measure structure on the parts of the sample 208. Additionally, or alternatively, the controller 150 is configured to identify defective structures by comparing the image representation with a reference.

In an embodiment the signal electrons associated with the detection signals are secondary electrons. The detection signals detected by the detector array 240 may be representative of the numbers of secondary electrons detected by the detector elements 265.

In an embodiment, the method is implemented by the controller 150 of an existing electron-optical apparatus 140. The existing electron-optical apparatus 140 may have its controller 150 updated so as to implement the method. The electron-optical apparatus 140 may already comprise the detector array 240 configured to generate detection signals indicative of secondary electrons. By providing that the method is performed on secondary electron signals, changes to the hardware may be reduced. An embodiment of the invention is expected to reduce the cost of improving the accuracy of detection signals.

It is not essential for the detection signals to be signals of secondary electrons. For example, in an alternative embodiment the detection signals are signals of backscattered electrons. The detector array 240 may be configured to detect backscattered electrons so as to generate detection signals indicative of the numbered of backscattered electrons detected.

Figure 10 schematically depicts a flow chart for determining the cross talk values. The method may be performed by the controller 150. As explained above, in an embodiment, the controller 150 is configured to determine the cross talk values which are indicative of proportions of each detection signal resulting from the detector element 265 detecting signal electrons emitted from areas other than its respective area.

As shown in Figure 10, in an embodiment the method comprises the step S101 of setting the electron-optical apparatus 140. For example, the electron-optical apparatus 140 may be started. The controller 150 may be configured to prepare the electron-optical apparatus 140 for determining the cross talk values.

As shown in Figure 10, in an embodiment, the method comprises the step S102 of selecting a method for determining the cross talk values. In an embodiment, one possible selection is direct measurement. For example, the controller 150 may be configured to determine the cross talk values by controlling the electron-optical apparatus 140 to measure detection signals resulting from subsets of the primary beams 211, 212, 213 on the sample 208. In an embodiment, an alternative possible selection is simulation. For example, the controller 150 may be configured to determine the cross talk values by simulating detection signals resulting from subsets of the primary beams 211, 212, 213 on the sample 208.

In an embodiment one of the possible options is selected. Depending on which option is selected in step S102, the method precedes along the left had branch or along the right hand branch shown in Figure 10. In an alternative embodiment, both options are followed. The results of both options may be combined to determine the cross talk values.

By directly measuring or simulating the cross talk values, the cross talk values may be determined accurately. It may not be necessary to make broad assumptions about the cross talk values. For example, individual cross talk values may be determined for different neighboring primary beams. The cross talk values may be determined more accurately compared to, for example, assuming that the nearest neighboring primary beams contribute equally to the cross talk while other primary beams have a zero cross talk. An embodiment of the invention is expected to improve the accuracy of the detection signals.

Figure 10, the left hand branch corresponds to the direct measurement option. As shown in Figure 10, in an embodiment the method comprises the step S103 of controlling activation of individual primary beams (or groups of primary beams) and controlling measurement of the detection signals resulting from the individual primary beams (or groups of primary beams). For example, the step S103 may comprise activating a first primary beam 211.

As shown in Figure 10, in an embodiment the method comprises the step S104 of compiling all columns to form the transfer matrix M. The outputs of the detector elements 265 may be measured for the first primary beam 211. Based on the measured detector outputs, the column of the transfer matrix M corresponding to the first primary beam 211 may be determined.

In an embodiment the step S103 comprises repeating the previous parts of step S103 for subsequent individual primary beams. For example, the process may be repeated for a second primary beam 212, a third primary beam 213 and so on. In an embodiment the process is repeated until all of the primary beams have been activated and had the detector elements outputs measured. Each primary beam populates a corresponding column of the transfer matrix M.

It is not essential for individual beams to be activated. In other words, it is not essential for the subsets of beams to be subsets of one primary beam each. In an alternative embodiment, each subset corresponds to a group of primary beams, where each group comprises a plurality of primary beams. For example, each subset may comprise a plurality of primary beams that are expected to have low cross talk with each other. For example, primary beams that are located distant from each other may be activated at the same time. This may increase the speed of measuring the cross talk values for the transfer matrix M.

As shown in Figure 10, in an embodiment the method comprises the step S105 of storing and/or recording the cross talk values for future use in cross talk reduction. For example, the transfer matrix M may be stored and/or recorded for future use. The controller 150 may be configured to store the cross talk values locally. In an embodiment the controller 150 is configured to store the cross talk values for use in a plurality of assessment processes. For example, the transfer matrix M may be calculated once, and that transfer matrix M may be used many times. The cross talk values of the transfer matrix M may be applicable for reducing the cross talk for a plurality of different assessment processes. The different assessment processes may correspond to different points in time. The different assessment processes may correspond to different layers of the sample 208, or to different samples 208. The cross talk values may be applicable to reduce the cross talk in different types of sample 208. It is possible that the type of layer or the type of sample 208 (for example the types of stretcher of the sample 208) may be some effect on the cross talk, and therefore on the cross talk values. However, the effect of the variation of sample type on the cross talk values may be sufficiently low that the same transfer matrix **M** can be used for a plurality of different samples 208 so as to reduce the cross talk in the detection signals.

For example, the controller 150 may be configured to reduce cross talk by operating on a plurality of sets of detection signals corresponding to different sets of areas using the same determined cross talk values. An embodiment of the invention is expected to increase throughput of assessing samples 208.

As shown in Figure 10, in an embodiment the method comprises the step S106 of ending the method.

In Figure 10, the right hand branch represents the simulation method for determining the cross talk values. As shown in Figure 10, in an embodiment the method comprises the step S113 of the inputting data into a simulation. The simulation may comprise a model, for example an electron-optical model. In an embodiment the controller 150 is configured to input into the simulation data characterizing an electron-optical setting. The electron-optical setting may refer to the electron-optics of the electron-optical apparatus 140.

For example, in an embodiment the data input into the simulation may comprise geometry of primary beams 211, 212, 213. For example, the data may comprise the width of individual primary beams, the shape of the individual primary beams, the current of the individual primary beams, and/or the pattern of the primary beams 211, 212, 213 that form the multi-beam grid. In an embodiment the data input into the simulation comprises scattering physics. For example, the simulation may comprise a model representative of how the charged particles are expected to scatter according to physical models.

In an embodiment the data input into the simulation comprises positions of the detector elements 265. For example, the size, shape and/or pattern of the detector elements 265 of the detector array 214 may be input into the simulation.

In an embodiment the data input into the simulation comprises one or more settings of the electron-optical apparatus 140. For example, the data may comprise the electric potential applied by the controller 150 for manipulating the primary beams 211, 212, 213. For example, the electric potentials controlled by the controller 150 to be applied to the electron-optical elements 261 of the electron-optical device 230 may be input into the simulation. In an embodiment the data input into the simulation comprises information identifying the hardware used to direct the primary beams 211, 212, 213. For example, when one or more components of the electron-optical apparatus 140 are replaced, then the data input into the simulation may be updated to reflect the change in hardware. This is because the electron-optical settings of the electron-optical apparatus 140 are expected to affect the cross talk values.

In an embodiment the data input into the simulation comprises a structure of the sample 208. For example, the intended structures on the sample 208 may be indicated in the simulation. The structures of the sample 208 may affect local charging of the sample 208. The local charging of the sample 208 may affect the path that the signal electrons follow from the sample 208 thereby affecting the cross talk values. However, it is not essential for the structure of the sample 208 to be taken into account. For example, the structure of the sample 208 may have a relatively small effect on the cross talk values such that this data is not necessary in order to determine cross talk values sufficiently accurate to reduce the cross talk.

As shown in Figure 10, in an embodiment the method comprises the step S114 of running the simulation. For example, the controller 150 may be configured to run the simulation so as to estimate the detector responses for each primary beam 211, 212, 213. By estimating the detector responses for each primary beam 211, 212, 213, the controller 150 may be configured to fill in the transfer matrix **M** with the determined cross talk values.

As explained above, in an embodiment the method may further comprise the step of storing and/or recording the cross talk values (e.g. the simulated cross talk values) for future use in cross talk correction, and subsequently ending the method.

In an embodiment, both the direct measurement and the simulation are performed in parallel flows. The cross talk values determined by direct measurement may be compared to the cross talk values determined by simulation. This may help to identify anomalous results. In an embodiment, the cross talk values determined by direct measurement may be combined by the cross talk values determined by simulation so as to determine combined cross talk values. Combined cross talk values may be stored and/or recorded by the controller 150 for future use in cross talk correction.

In an embodiment, the cross talk values may be expected to change when the electron-optical setting changes. For example, when different electric potentials are used by the electron-optical device 230 and/or when different pieces of hardware of the electron-optical apparatus 140 are used, the cross talk values are expected to vary. As another example, when the arrangement of primary beams is reconfigured (e.g. when the number of primary beams is changed and/or the spacing between primary beams is changed), the cross talk values are expected to vary. A different electron-optical setting includes a different changed beam arrangement. In an embodiment the controller 150 is configured to determine at least one additional set of cross talk values corresponding to at least one different electron-optical setting. For example, the controller 150 may be configured to determine a first set of cross talk values and to sue those cross talk values to reduce cross talk while the electron-optical setting remains the same (or when the electron-optical setting reverts to this electron-optical setting). The controller 150 may subsequently determine a second set of cross talk values corresponding to a second electron-optical setting. The second set of cross talk values may be used by the controller 150 to reduce the cross talk in detection signals that are generated when the second electron-optical is applied.

It may take some time to determine the cross talk values. However, the determined cross talk values may be used for a plurality of scans. The time saved in applying the cross talk values to reduce the cross talk may be greater than the time required to determine the cross talk values in the first place. An embodiment of the invention is expected to increase throughput of assessing samples 208.

By reducing the cross talk using a computational approach, it is possible to preserve the wide apertures and high throughput of the electron-optical apparatus 140. Algorithmic decoupling is used to avoid narrow apertures or physically restrictive hardware that would otherwise sacrifice signal collection. An embodiment of the invention is expected to maintain high signal electron counts and shorter dwell times.

In an embodiment the controller 150 is configured to process the determined cross talk values so as to generate the inverse or the pseudoinverse of the transfer matrix **M.** The processing may comprise optimization so as to improve the stability of the pseudoinverse of the transfer matrix **M.** In an embodiment the controller 150 is configured to optimize the calculation of the pseudoinverse so as to reduce noise and/or artifacts.

In an embodiment the controller 150 is configured to reduce the condition number of the transfer matrix **M.** For example, in an embodiment the controller 150 is configured to perform Tikhonov or ridge regularization. The inverse calculation may be modified to include a damping term before or during the inversion of the transfer matrix **M.** This can help to smooth out the impact of very small singular values within the transfer matrix **M.** In an embodiment the controller 150 is configured to tune the damping term so as to reduce the noise sensitivity and mitigate large artifacts. In an embodiment the controller 150 is configured to calibrate the damping term by trial scans, for example.

In an embodiment the controller 150 is configured to iteratively step towards the pseudoinverse, instead of directly calculating the pseudoinverse. For example, the controller 150 may be configured to iteratively solve for the magnitude of **MX-Y=0.** In an embodiment the controller 150 is configured to select the step size. This can help to reduce the possibility of noise being undesirably amplified in the pseudoinverse of the transfer matrix **M.**

In an embodiment the controller 150 is configured to control the electron-optical apparatus 140 to measure multiple sets of cross talk values corresponding to varying beam conditions, for example. These measured cross talk values may be combined which can help to average out undesirable random noises. The transfer matrix **M** may be more robust, thereby increasing the robustness of the pseudoinverse.

In an embodiment the controller 150 is configured to embed the transfer matrix M into a machine learning model such a neural network. The machine learning model is configured to learn a way (in particular a robust and nonlinear way) to invert the transfer matrix **M** or to approximate the pseudoinverse of the transfer matrix **M.**

In an embodiment the controller 150 is configured to compute the pseudoinverse of the transfer matrix **M** using a singular value decomposition so as to truncate extremely small singular values in the transfer matrix **M** that can otherwise cause instability in the pseudoinverse.

In an embodiment the controller 150 is configured to apply spatial smoothing to the transfer matrix **M** or in the pseudoinverse. For example, large variations of the values between neighboring beam signals may be reduced. This can help to limit the amplitude of undesirable noise peaks.

In an embodiment the controller 150 is configured to control the electron-optical apparatus 140 to determine cross talk values for a plurality of different settings of the detector array 240. The determined cross talk values corresponding to the different detection settings may be combined so as to generate combined cross talk values. This can help to reduce the effect of any signal noisy measurement.

In an embodiment the controller 150 is configured to perform a plurality of optimization processes so as to improve the robustness of the pseudoinverse of the transfer matrix **M.**

In an embodiment the controller 150 is configured to operate on the detection signals using cross talk values. In an embodiment the cross talk values are comprised in a transfer matrix **M.** Alternatively, the controller 150 may be configured to operate on the detection signals without using a matrix, for example, by performing a mathematical operation using weighting factors for different detection signals. The weighting factors are related to the cross talk values. For example, in an embodiment the controller 150 is configured to add the detection signals from neighboring primary beams to the detection signal of a given primary beam with certain weighting factors related to the cross talk values.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

In an embodiment a non-transitory computer readable medium stores instructions for a processor of a controller (e.g. the controller 109) to carry out a method as described above. Exemplary embodiments of the present disclosure are set out in the following numbered clauses:
1. A charged particle-optical apparatus configured to direct charged particles toward a sample, the charged particle-optical apparatus comprising:
   a charged particle-optical device configured to direct a plurality of beams of charged particles along respective beam paths toward a sample;
   a detector array of detector elements configured to detect signal charged particles emitted from respective areas of a surface of the sample so as to generate respective detection signals; and
   a controller configured to:
      determine cross talk values indicative of proportions of each detection signal resulting from the detector element detecting signal charged particles emitted from areas other than its respective area; and
      reduce cross talk by operating on the detection signals using the determined cross talk values based on signals resulting from subsets of the primary beams on the sample.
2. The charged particle-optical apparatus of clause 1, wherein the controller is configured to determine the cross talk values by:
   controlling the charged particle-optical apparatus to measure detection signals resulting from subsets of the primary beams on the sample.
3. The charged particle-optical apparatus of clause 1 or 2, wherein the controller is configured to determine the cross talk values by:
   simulating detection signals resulting from subsets of the primary beams on the sample.
4. The charged particle-optical apparatus of any preceding clause, wherein the cross talk values form a transfer matrix, and the controller is configured to reduce the cross talk by operating on the detection signals by an inverse of the transfer matrix.
5. The charged particle-optical apparatus of clause **4,** wherein the controller is configured to calculate the inverse of the transfer matrix using a regularization technique.
6. The charged particle-optical apparatus of clause 4 or 5, wherein the controller is configured to calculate the inverse of the transfer matrix using an iterative solver.
7. The charged particle-optical apparatus of any preceding clause, wherein the cross talk values form a transfer matrix, and the controller is configured to reduce the cross talk by operating on the detection signals by a pseudoinverse of the transfer matrix.
8. The charged particle-optical apparatus of clause 7, wherein the controller is configured to calculate the pseudoinverse of the transfer matrix using a regularization technique.
9. The charged particle-optical apparatus of clause 7 or 8, wherein the controller is configured to calculate the pseudoinverse of the transfer matrix using an iterative solver.
10. The charged particle-optical apparatus of any of clauses 7-9, wherein the pseudoinverse of the transfer matrix is a Moore-Penrose pseudoinverse.
11. The charged particle-optical apparatus of any preceding clause, wherein the controller is configured to determine the cross talk values by controlling activation of individual primary beams and controlling measurement of the detection signals resulting from the individual primary beams.
12. The charged particle-optical apparatus of any of clauses 1-10, wherein the controller is configured to determine the cross talk values by controlling activation of groups of primary beams and controlling measurement of the detection signals resulting from the groups of primary beams, each group comprising a plurality of primary beams.
13. The charged particle-optical apparatus of any preceding clause, wherein the controller is configured to determine at least one additional set of cross talk values corresponding to at least one different charged particle-optical setting.
14. The charged particle-optical apparatus of any preceding clause, wherein the controller is configured to input into a simulation data characterising an charged particle-optical setting so as to simulate the detection signals.
15. The charged particle-optical apparatus of clause 14, wherein the data comprise geometry of the primary beams.
16. The charged particle-optical apparatus of clause 14 or 15, wherein the data comprise positions of the detector elements.
17. The charged particle-optical apparatus of any of clauses 14-16, wherein the data comprise electric potentials applied for manipulating the primary beams.
18. The charged particle-optical apparatus of any of clauses 14-17, wherein the data comprise hardware used to direct the primary beams.
19. The charged particle-optical apparatus of any of clauses 14-18, wherein the data comprise a structure of the sample.
20. The charged particle-optical apparatus of any preceding clause, wherein the signal particles are secondary electrons.
21. The charged particle-optical apparatus of any preceding clause, wherein the controller is configured to reduce cross talk by operating on a plurality of sets of detection signals corresponding to different sets of areas using the same determined cross talk values.
22. A method for reducing cross talk of detection signals, of signal charged particles emitted from respective areas of a surface of a sample resulting from primary beams of charged particles on the sample, detected by detector elements, the method comprising:
   determining cross talk values indicative of proportions of each detection signal resulting from the detector element detecting signal charged particles emitted from areas other than its respective area; and
   reducing cross talk by operating on the detection signals using the determined cross talk values based on signals resulting from subsets of the primary beams on the sample.
23. The method of clause 22, wherein the cross talk values are determined by:
   measuring detection signals resulting from subsets of the primary beams on the sample.
24. The method of clause 22 or 23, wherein the cross talk values are determined by:
   simulating detection signals resulting from subsets of the primary beams on the sample.
25. A method for assessing a sample with primary beams of charged particles,, the method comprising:
   directing a plurality of primary beams of charged particles toward a sample;
   detecting with detector elements signal charged particles emitted from respective areas of a surface of the sample so as to generate detection signals.
   determining cross talk values indicative of proportions of each detection signal resulting from the detector element detecting signal charged particles emitted from areas other than its respective area; and
   reducing cross talk of the detection signals by operating on the detection signals using the determined cross talk values based on signals resulting from subsets of the primary beams on the sample.
26. The method of clause 25, wherein the cross talk values are determined by:
   measuring detection signals resulting from subsets of the primary beams on the sample.
27. The method of clause 25 or 26, wherein the cross talk values are determined by:
   simulating detection signals resulting from subsets of the primary beams on the sample.
28. A computer readable medium storing instructions that, when executed by at least one processor, cause a computing device to perform a method for reducing cross talk of detection signals, detected by detector elements, of signal charged particles emitted from respective areas of a surface of a sample resulting from primary beams of charged particles on the sample, the method comprising:
   determining cross talk values indicative of proportions of each detection signal resulting from the detector element detecting signal charged particles emitted from areas other than its respective area; and
   reducing cross talk by operating on the detection signals using the determined cross talk values based on signals resulting from subsets of the primary beams on the sample.
29. The computer readable medium of clause 28, wherein the cross talk values are determined by:
   controlling a charged particle-optical apparatus to measure detection signals resulting from subsets of the primary beams on the sample.
30. The computer readable medium of clause 28 or 29, wherein the cross talk values are determined by:
   simulating detection signals resulting from subsets of the primary beams on the sample.
31. A scanning electron microscope, SEM, for scanning a sample with electrons and detecting signal electrons emitted from the sample, the SEM comprising:
   an electron-optical device configured to direct a plurality of electron beams onto a field of view of the sample;
   a detector comprising a plurality of detector elements configured to detect signal electrons emitted from respective locations within the field of view, so as to generate SEM scan data; and
   a controller configured to:
      determine cross talk values indicative of proportions of each SEM scan datum resulting from the detector element detecting signal electrons emitted from locations other than its respective location; and
      reduce cross talk by operating on the SEM scan data using the determined cross talk values based on SEM scan data resulting from subsets of the electron beams on the sample.
32. The SEM of clause 31, wherein the controller is configured to determine the cross talk values by:
   controlling the SEM to generate SEM scan data resulting from subsets of the electron beams on the sample.
33. The SEM of clause 31 or 32, wherein the controller is configured to determine the cross talk values by:
   simulating SEM scan data resulting from subsets of the electron beams on the sample.
34. A method of operating a scanning electron microscope, SEM, for scanning a sample with electrons and detecting signal electrons emitted from the sample, the method comprising:
   an electron-optical device of the SEM directing a plurality of electron beams onto a field of view of the sample;
   a plurality of detector elements of a detector of the SEM detecting signal electrons emitted from respective locations within the field of view, so as to generate SEM scan data; and
   a controller of the SEM determining cross talk values indicative of proportions of each SEM scan datum resulting from the detector element detecting signal electrons emitted from locations other than its respective location; and
   the controller reducing cross talk by operating on the SEM scan data using the determined cross talk values based on SEM scan data resulting from subsets of the electron beams on the sample.
35. The method of clause 34, wherein the cross talk values are determined by:
   controlling the SEM to generate SEM scan data resulting from subsets of the electron beams on the sample.
36. The method of clause 34 or 35, wherein the cross talk values are determined by:
   simulating SEM scan data resulting from subsets of the electron beams on the sample.
37. A non-transitory computer readable medium that stores instructions for a processor of a controller to carry out a method of operating a scanning electron microscope, SEM, the method comprising:
   controlling an electron-optical device of the SEM to direct an electron beam onto a field of view of a sample;
   controlling a plurality of detector elements of a detector of the SEM to detect signal electrons emitted from respective locations within the field of view, so as to generate SEM scan data;
   determining cross talk values indicative of proportions of each SEM scan datum resulting from the detector element detecting signal electrons emitted from locations other than its respective location; and
   reducing cross talk by operating on the SEM scan data using the determined cross talk values based on SEM scan data resulting from subsets of the electron beams on the sample.
38. The non-transitory computer readable medium of clause 37, wherein the cross talk values are determined by:
   controlling the SEM to generate SEM scan data resulting from subsets of the electron beams on the sample.
39. The non-transitory computer readable medium of clause 37 or 38, wherein the cross talk values are determined by:
   simulating SEM scan data resulting from subsets of the electron beams on the sample.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A charged particle-optical apparatus configured to direct charged particles toward a sample, the charged particle-optical apparatus comprising:
a charged particle-optical device configured to direct a plurality of beams of charged particles along respective beam paths toward a sample;
a detector array of detector elements configured to detect signal charged particles emitted from respective areas of a surface of the sample so as to generate respective detection signals; and
a controller configured to:
determine cross talk values indicative of proportions of each detection signal resulting from the detector element detecting signal charged particles emitted from areas other than its respective area; and
reduce cross talk by operating on the detection signals using the determined cross talk values based on signals resulting from subsets of the primary beams on the sample.

2. The charged particle-optical apparatus of claim 1, wherein the controller is configured to determine the cross talk values by:
controlling the charged particle-optical apparatus to measure detection signals resulting from subsets of the primary beams on the sample.

3. The charged particle-optical apparatus of claim 1 or 2, wherein the controller is configured to determine the cross talk values by:
simulating detection signals resulting from subsets of the primary beams on the sample.

4. The charged particle-optical apparatus of any preceding claim, wherein the cross talk values form a transfer matrix, and the controller is configured to reduce the cross talk by operating on the detection signals by an inverse of the transfer matrix and/or a pseudoinverse of the transfer matrix.

5. The charged particle-optical apparatus of claim **4,** wherein the controller is configured to calculate the inverse of the transfer matrix and/or the pseudoinverse of the transfer matrix using a regularization technique and/or an iterative solver.

6. The charged particle-optical apparatus of claim 4 or 5, wherein the pseudoinverse of the transfer matrix is a Moore-Penrose pseudoinverse.

7. The charged particle-optical apparatus of any preceding claim, wherein the controller is configured to determine the cross talk values by controlling activation of individual primary beams and controlling measurement of the detection signals resulting from the individual primary beams.

8. The charged particle-optical apparatus of any of claims 1-6, wherein the controller is configured to determine the cross talk values by controlling activation of groups of primary beams and controlling measurement of the detection signals resulting from the groups of primary beams, each group comprising a plurality of primary beams.

9. The charged particle-optical apparatus of any preceding claim, wherein the controller is configured to determine at least one additional set of cross talk values corresponding to at least one different charged particle-optical setting.

10. The charged particle-optical apparatus of any preceding claim, wherein the controller is configured to input into a simulation data characterising an charged particle-optical setting so as to simulate the detection signals.

11. The charged particle-optical apparatus of claim 10, wherein the data comprise geometry of the primary beams, positions of the detector elements, electric potentials applied for manipulating the primary beams, hardware used to direct the primary beams, and/or a structure of the sample.

12. The charged particle-optical apparatus of any preceding claim, wherein the signal particles are secondary electrons.

13. The charged particle-optical apparatus of any preceding claim, wherein the controller is configured to reduce cross talk by operating on a plurality of sets of detection signals corresponding to different sets of areas using the same determined cross talk values.

14. A method for reducing cross talk of detection signals, of signal charged particles emitted from respective areas of a surface of a sample resulting from primary beams of charged particles on the sample, detected by detector elements, the method comprising:
determining cross talk values indicative of proportions of each detection signal resulting from the detector element detecting signal charged particles emitted from areas other than its respective area; and
reducing cross talk by operating on the detection signals using the determined cross talk values based on signals resulting from subsets of the primary beams on the sample.

15. A method for assessing a sample with primary beams of charged particles, the method comprising:
directing a plurality of primary beams of charged particles toward a sample;
detecting with detector elements signal charged particles emitted from respective areas of a surface of the sample so as to generate detection signals.
determining cross talk values indicative of proportions of each detection signal resulting from the detector element detecting signal charged particles emitted from areas other than its respective area; and
reducing cross talk of the detection signals by operating on the detection signals using the determined cross talk values based on signals resulting from subsets of the primary beams on the sample.
